(19)

Europäisches
Patentamt
European
Patent Office
Office européen
des brevets

(11) **EP 2 919 573 A2**

(12) **EUROPEAN PATENT APPLICATION**

(43) Date of publication:
**16.09.2015 Bulletin 2015/38**

(51) Int Cl.:
**H05K 13/04** *(2006.01)*     **H05K 13/08** *(2006.01)*
**H05K 13/02** *(2006.01)*

(21) Application number: **15151116.9**

(22) Date of filing: **14.01.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **14.03.2014   JP 2014051433**

(71) Applicant: **OMRON CORPORATION
Kyoto-shi,  Kyoto 600-8530 (JP)**

(72) Inventors:
• **Taishi, Yoshitaka
Kyoto-shi, Kyoto 600-8530 (JP)**
• **Maekawa, Junichi
Kyoto-shi, Kyoto 600-8530 (JP)**
• **Kawai, Hajime
Kyoto-shi, Kyoto 600-8530 (JP)**

(74) Representative: **Global IP Europe
Patentanwaltskanzlei
Pfarrstraße 14
80538 München (DE)**

(54) **Method for detecting components in carrier tape, sensor module, splicing device, and component mounting device**

(57)     A method for using an optical displacement sensor to detect the presence of components in a carrier tape includes the following four steps. In the first step, a displacement sensor measures the displacement of a plurality of empty pockets in the carrier tape. In the second step, the measured displacement of the empty pockets is statistically processed, and a first range of displacement is set for determining empty pockets. In the third step, the displacement sensor measures the displacement of pockets in the carrier tape. In the fourth step, a pocket is determined to be an empty pocket if the measured displacement of the pocket is within the first range, and a component is determined to be in the pocket if the measured displacement of the pocket is outside the first range.

FIG. 9

**Description**

FIELD

The present invention relates to a method for detecting the presence of components in a carrier tape, and to a sensor module, a splicing device, and a component mounting device for executing said method.

BACKGROUND

With an electronic component mounting device used to place electronic components on a substrate, the electronic components are held in pockets on a carrier tape, this carrier tape is moved along by a tape feeder, and the electronic components in the pockets are transferred to and placed on the substrate by a placement head. The carrier tape is generally wound onto a reel. If one of the components in the carrier tape should break, the reel has to be replaced with a new tape reel.

In this reel replacement work, splicing processing to join two carrier tapes together with splicing tape is employed so that the work of the electronic component mounting device will not be stopped. Patent Literature 1 (WO 2013/157109 pamphlet) discloses an automatic splicing device with which this tape splicing can be carried out automatically. The automatic splicing device pertaining to Patent Literature 1 comprises a photosensor capable of distinguishing between empty pockets on a carrier tape and tape portions other than pockets. This photosensor measures the pitch of pockets filled with components, and measures the empty pocket region to which empty pockets located at the carrier tape ends are contiguous. This automatic splicing device determines how much margin is needed to affix the splicing tape, on the basis of the measured pitch. The automatic splicing device then cuts out any unnecessary empty pocket regions, and automatically affixes two pieces of carrier tape.

Also, a carrier tape that has undergone this splicing processing has continuous empty pockets at the seam. Accordingly, stopping the operation of the placement head at the seam and feeding the tape to the end of the seam is effective in terms of efficiently performing the mounting of electronic components. Patent Literature 2 (Japanese Laid-Open Patent Application 2007-214476) discloses a component mounting device having a tape feed function such as this. With the component mounting device pertaining to Patent Literature 2, if a camera disposed near the placement head for moving and placing electronic components recognizes an empty pocket, the placement head and the camera are moved above the carrier tape. This component mounting device then repeatedly executes pitch feed of the carrier tape until the camera detects a pocket that is filled with a component.

SUMMARY

With the invention pertaining to Patent Literature 2, the camera has to be moved when a seam is detected, and this movement diminishes work efficiency. Therefore, in terms of mounting efficiency it is preferable to dispose a photosensor or the like in the carrier tape feed mechanism, and execute automatic tape feed while the photosensor detects empty pockets.

With the invention pertaining to Patent Literature 1, a technique is disclosed for using a photosensor to distinguish pockets filled with components from empty pockets of the carrier tape and tape portions other than pockets. This makes use of the fact that the output of the photosensor is different for empty pockets, for tape portions, and for pockets filled with components. Incidentally, it is difficult to obtain a stable signal capable of recognizing three portions from a photosensor, as is discussed in Patent Literature 1. Carrier tapes are specified in IEC60286-3 ed. 5.0 and elsewhere, but only the pitch of feed holes and the positional relation between feed holes and pockets (there are a number of variations) are specified. Therefore, the pitch width between pockets varies with the tape, and furthermore the size and shape of the components inserted into the pockets vary considerably. Therefore, depending the component, it can be difficult to set a threshold value for distinguishing between the output of the photosensor in the tape portion, and the output of the photosensor in a pocket filled with a component. Furthermore, even if an empty pocket is distinguished, the system needs to be capable of distinguishing empty pockets of various depths.

In view of this, it is an object of the present invention to solve the above problems and to provide a method with which the presence of components in a carrier tape can be detected by a photosensor, as well as a sensor module, a splicing device, and a component mounting device for executing said method.

In a first mode of the present invention, a method in which an optical displacement sensor detects the presence of components in a carrier tape includes the following four steps. In the first step, a displacement sensor measures the displacement of a plurality of empty pockets in the carrier tape. In the second step, the measured displacement of the empty pockets is statistically processed, and a first range of displacement is set for determining empty pockets. In the third step, the displacement sensor measures the displacement of pockets in the carrier tape. In the fourth step, a pocket is determined to be an empty pocket if the measured displacement of the pocket is within a first range, and determining that a component is in the pocket if the measured displacement of the pocket is outside the first range.

With this method, the displacement sensor may receive from the carrier tape feed mechanism a trigger signal indicating that the measurement region of the displacement sensor has reached the center position of a pocket. Also, upon receiving the trigger signal, the displacement sensor may measure the displacement of a plurality of empty pockets, and the displacement of the pockets.

The first range may be determined by the standard deviation and the average value of the displacement of a plurality of empty pockets.

In a second mode of the present invention, a sensor module that includes an optical displacement sensor for detecting the presence of components in a carrier tape comprises a light emitter, a light receiver, a arithmetic section, a setting section, a memory, and a determination section. The light emitter emits light. The light receiver receives the light. The arithmetic section calculates displacement from the intensity of light emitted by the light emitter and received by the light receiver, for the pockets of the carrier tape. The setting section statistically processes displacement obtained when the light emitter emits light and the light receiver receives light, for a plurality of empty pockets of the carrier tape, and sets a first range of displacement for determining the empty pockets. The memory stores threshold values that define a first range. The determination section determines a pocket to be an empty pocket if the calculated displacement is within the first range, and determines that a component is in the pocket if the calculated displacement is outside the first range.

This sensor module may further include a trigger receiver. The trigger receiver receives a trigger signal indicating that the measurement region of the displacement sensor has reached the center position of a pocket. The arithmetic section calculates displacement from the intensity of light received by the light receiver when the trigger receiver has received a trigger signal.

The component mounting device in a third mode of the present invention comprises a tape feeder, a placement head, and a controller. The tape feeder sends components held in the pockets of a carrier tape to a component removal position. The placement head removes components from the pockets and moves them for placement on a substrate. The controller controls the tape feeder and the placement head. The tape feeder has a sensor module that includes an optical displacement sensor. The sensor module includes the above-mentioned light emitter, the above-mentioned light receiver, a arithmetic section, the above-mentioned determination section, and a signal transmitter. The arithmetic section calculates displacement from the intensity of light received by the light receiver when the pocket has arrived at a component testing position before arriving at the component removal position. The signal transmitter transmits to the controller an output signal indicating the pocket determination result produced by the determination section. The controller halts movement and placement by the placement head when a pocket determined to be an empty pocket is sent to the component removal position when a pocket has been determined to be an empty pocket.

The sensor module may further include the above-mentioned setting section. Also, the controller may send the sensor module a trigger signal indicating that the center position of the pocket has arrived at the component testing position. The sensor module may further include a trigger receiver that receives trigger signals. The arithmetic section may calculate displacement from the intensity of light received by the light receiver when the trigger receiver has received a trigger signal.

The splicing device in a fourth mode of the present invention is a splicing device that splices a first carrier tape and a second carrier tape, and comprises a first tape feed mechanism, a first sensor module, a first cutting mechanism, a first positioning mechanism, a second tape feed mechanism, a second sensor module, a second cutting mechanism, a second positioning mechanism, a tape splicing mechanism, and a controller. The first tape feed mechanism feeds the first carrier tape to a first cutting position. The first sensor module includes an optical displacement sensor. The first cutting mechanism cuts the first carrier tape at the first cutting position. The first positioning mechanism positions the cut first carrier tape at a tape splicing position. The second tape feed mechanism feeds the second carrier tape to a second cutting position. The second sensor module includes an optical displacement sensor. The second cutting mechanism cuts the second carrier tape at the second cutting position. The second positioning mechanism positions the cut second carrier tape at the tape splicing position. The tape splicing mechanism splices the first carrier tape and the second carrier tape with splicing tape at the tape splicing position. The controller controls the first tape feed mechanism, the first cutting mechanism, the first positioning mechanism, the second tape feed mechanism, the second cutting mechanism, the second positioning mechanism, and the tape splicing mechanism.

The first sensor module includes a first light emitter, a first light receiver, a first arithmetic section, a first memory, a first determination section, and a first signal transmitter. The first light emitter emits light. The first light receiver receives the light. The first arithmetic section calculates a first displacement from the intensity of light received by the first light receiver when a first pocket of the first carrier tape has arrived at a first tape testing position before arriving at the first cutting position. The first memory stores threshold values that define a first range of the first displacement for determining there is an empty pocket. The first determination section determines the first pocket to be an empty pocket if the first displacement is within the first range, and determines that a component is in the first pocket if the first displacement is outside the first range. The first signal transmitter transmits to the controller a first output signal indicating the first pocket determination result produced by the first determination section.

The second sensor module includes a second light emitter, a second light receiver, a second arithmetic section, a second memory, a second determination section, and a second signal transmitter. The second light emitter emits light. The second light receiver receives the light. The second arithmetic section calculates a second displacement from the intensity of light received by the second light receiver when a second pocket of the second carrier tape has arrived at a second tape testing position before arriving at the second cutting position. The second memory stores threshold values that define a second range of the second displacement for determining there is an empty pocket. The second determination section determines the second pocket to be an empty pocket if the second displacement is within the second range, and determines that a component is in the second pocket if the second displacement is outside the second range. The second signal transmitter transmits to the controller a second output signal indicating the second pocket determination result produced by the second determination section.

Upon receiving the first output signal indicating that the first determination section has determined that there is a component, the controller causes the first cutting mechanism to cut the first carrier tape when a first portion of the first carrier tape, which is a portion of the first pocket between the pocket located a specific number on the tape splicing position side from the pocket in which the component was determined to be present, and the pocket located (the specific number + 1) on the tape splicing position side, arrives at the first cutting position. When the second determination section has determined that there is a component, the controller causes the second cutting mechanism to cut the second carrier tape when a second portion of the second carrier tape, which is a portion of the second pocket between the pocket located a specific number on the tape splicing position side from the pocket in which the component was determined to be present, and the pocket located (the specific number + 1) on the tape splicing position side, arrives at the second cutting position.

The specific number may be found from the pitch of the first pocket and the pitch of the second pocket, and the required length of the splicing tape.

The first sensor module may further include a first setting section. The second sensor module may further include a second setting section. The first setting section statistically processes the first displacement obtained when the first light emitter emits light and the first light receiver receives light, for a plurality of empty pockets of the first carrier tape, and sets the first range. The second setting section statistically processes the second displacement obtained when the second light emitter emits light and the second light receiver receives light, for a plurality of empty pockets of the second carrier tape, and sets the second range.

The controller may send the first sensor module a first trigger signal indicating that the center position of the first pocket has arrived at the first tape testing position. The first sensor module further may further include a first trigger receiver that receives the first trigger signal. The first arithmetic section may calculate the first displacement from the intensity of light received by the first light receiver when the first trigger receiver has received the first trigger signal. The controller may send the second sensor module a second trigger signal indicating that the center position of the second pocket has arrived at the second tape testing position. The second sensor module may further include a second trigger receiver that receives the second trigger signal. The second arithmetic section may calculate the second displacement from the intensity of light received by the second light receiver when the second trigger receiver has received the second trigger signal.

The first range may be defined by the standard deviation and the average value of the first displacement of the plurality of empty pockets. The second range may be defined by the standard deviation and the average value of the second displacement of the plurality of empty pockets.

With the method pertaining to the first mode, the sensor module pertaining to the second mode, the component mounting device pertaining to the third mode, and the splicing device pertaining to the fourth mode, the displacement of a plurality of empty pockets is statistically processed, and a first range of displacement is set for determining that a pocket is empty. A pocket is determined to be an empty pocket when the measured pocket displacement is within the first range, and a component is determined to be in a pocket when the measured pocket displacement is outside the first range. An empty pocket tends to have a different amount of displacement from that of a pocket containing a component, or a taper portion. Therefore, a photosensor will be able to stably detect whether there are components in a carrier tape.

BRIEF DESCRIPTION OF THE DRAWINGS

FIG. 1 is a diagram of a carrier tape that is spliced by a splicing device;
FIG. 2 is a cross section along the II-II line in FIG. 1;
FIG. 3 shows an example of a splicing device equipped with the sensor module pertaining to an embodiment;
FIG. 4 is a diagram illustrating empty pockets that are necessary for tape splicing;

FIG. 5 is an oblique view of the sensor module pertaining to an embodiment;

FIG. 6 is a function block diagram of the sensor module pertaining to an embodiment;

FIG.7 is a graph of an example of displacement that varies when the carrier tape is moved continuously;

FIG. 8 is a diagram illustrating that displacement fluctuates greatly in a pocket with a component;

FIG. 9 is a flowchart of the flow of processing in detection performed by a sensor module;

FIG. 10 is a flowchart of the flow of operation of the controller of a splicing device;

FIG. 11 is a plan view of the component mounting device pertaining to an embodiment;

FIG. 12 is a partial cross section of the component mounting device pertaining to an embodiment;

FIG. 13 is a diagram illustrating the configuration of the tape feeder pertaining to an embodiment;

FIG. 14 is a diagram illustrating a tape feed mechanism in the tape feeder pertaining to an embodiment; and

FIG. 15 is a flowchart of the flow of operation of the controller in the component mounting device pertaining to an embodiment.

DETAILED DESCRIPTION

First Embodiment

An embodiment of the present invention will now be described through reference to the drawings. In the drawings referred to below, members that are the same or equivalent will be numbered the same.

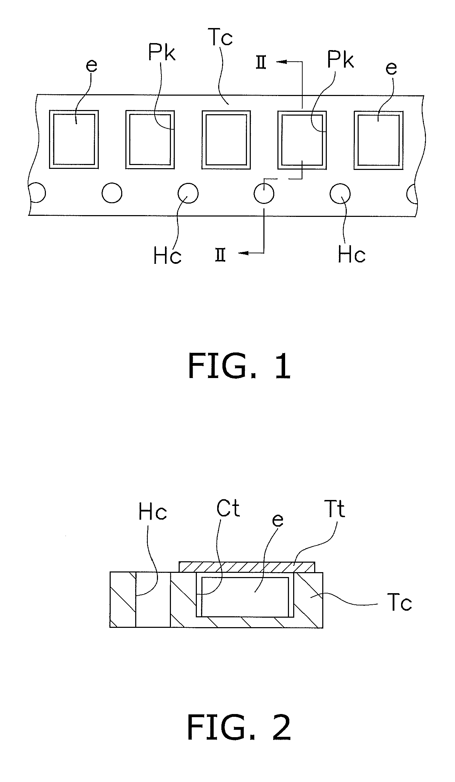

A splicing device is a device that joins pieces of the carrier tape Tc shown in FIGS. 1 and 2. As shown in FIG. 1, the carrier tape Tc is formed in a slender shape with a specific width, and a plurality of pockets Pk are spaced apart at a specific pitch in the lengthwise direction. These pockets Pk hold components e that are to be mounted on a circuit board. The components are usually electronic components, so in the following description they will be referred to as electronic components e. The upper part of the pockets Pk is open. As shown in FIG. 2, the upper part of the pockets Pk is covered by top tape Tt affixed to the surface of the carrier tape Tc.

Feed holes Hc are provided on one side in the width direction of the carrier tape Tc. The pitch spacing Pc of the feed holes Hc is set to a specific value according to IEC60286-3 ed. 5.0 or another such standard. The pitch spacing Pc of the feed holes Hc is set by standard to be the same as the pitch spacing Pp of the pockets, or to be a specific multiple of the pitch spacing Pp. The positional relation between the feed holes Hc and the pockets Pk is similarly set at the pitch spacing Pp of the various pockets. Therefore, as long as the pitch spacing Pp of the pockets Pk is known, the device that moves the carrier tape Tc can estimate where the pockets are located from the amount of movement fo the feed holes Hc.

The carrier tape Tc is usually wound onto a reel in order to attach it to the tape feeder of a component mounting device. Therefore, the splicing device is configured so that the end of the carrier tape wound onto the current reel mounted to the current tape feeder is connected to the start of the carrier tape wound onto the next reel that will replace the current one.

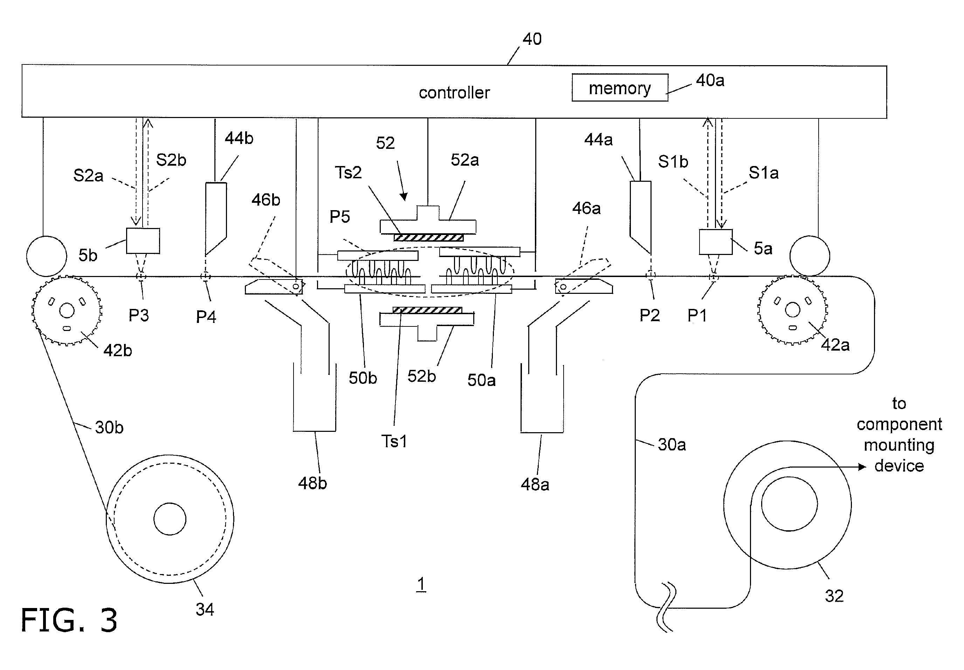

FIG. 3 is an example of a splicing device 1 equipped with the sensor module pertaining to this embodiment. The splicing device 1 comprises a first tape feed mechanism 42a, a first sensor module 5a, a first cutting mechanism 44a, a first movable conveyance path 46a, a first disposal site 48a, a first positioning mechanism 50a, a second tape feed mechanism 42b, a second sensor module 5b, a second cutting mechanism 44b, a second movable conveyance path 46b, a second disposal site 48b, a second positioning mechanism 50b, a tape splicing mechanism 52, and a controller 40. In FIG. 3, the two pieces of carrier tape Tc that will be spliced by the splicing device 1 are shown as the first carrier tape 30a and the second carrier tape 30b. Also, the current reel is shown as the reel 32 and the next reel as the reel 34 in FIG. 3.

The first tape feed mechanism 42a feeds the first carrier tape 30a to a first cutting position P2. The first cutting position P2 is the position where the first cutting mechanism 44a (discussed below) cuts the first carrier tape 30a. The first tape feed mechanism 42a is constituted by a sprocket that engages with the feed holes Hc of the first carrier tape 30a, and a motor, a gear, etc., that controls the rotation of this sprocket.

The first sensor module 5a includes an optical displacement sensor. The first sensor module 5a tests the pocket Pk of the first carrier tape 30a that is fed in from the first tape feed mechanism 42a (hereinafter this pocket will be referred to as the first pocket Pk1), using a first trigger signal S1 a sent in from the controller 40 as a trigger. The first sensor module 5a then determines whether or not this first pocket Pk1 is holding an electronic component e. The top tape Tt of the first carrier tape 30a is preferably transparent so that the first sensor module 5a, which is an optical displacement sensor, can make this determination. The place where the first sensor module 5a tests the first pocket Pk1 is called the first tape testing position P1. The first tape testing position P1 is a measurement region in which the first sensor module 5a can measure displacement. That is, the first pocket Pk1 of the first carrier tape 30a arrives at the first tape testing position P1 before it arrives at the first cutting position P2. The first sensor module 5a sends a first output signal S1 b indicating the determination result for the first pocket Pk1 to the controller 40. The configuration and operation of the first sensor module 5a will be described in detail below.

The first cutting mechanism 44a cuts the first carrier tape 30a at the first cutting position P2. The first cutting mechanism 44a includes, for example, a cutter and a pressing member that is used for fixing the first carrier tape 30a. The first cutting mechanism 44a is driven by a drive signal from the controller 40.

The first movable conveyance path 46a sends to the first disposal site 48a the portion of the first carrier tape 30a that has been cut off by the first cutting mechanism 44a and is no longer needed. The first movable conveyance path 46a then sends to a tape splicing position P5 the first carrier tape 30a that has been cut by the first cutting mechanism 44a and is to be spliced with the second carrier tape 30b. The first movable conveyance path 46a is constituted, for example, by a movable member that is driven by a solenoid or the like.

The first positioning mechanism 50a positions the cut first carrier tape 30a at the tape splicing position P5. The cut first carrier tape 30a is butted up against the cut second carrier tape 30b at the tape splicing position. The first positioning mechanism 50a fixes the first carrier tape 30a when the first carrier tape 30a and the second carrier tape 30b are being spliced. For example, the first positioning mechanism 50a is a mechanism that clamps the first carrier tape 30a with members including a positioning pin and a positioning hole from above and below.

The second tape feed mechanism 42b feeds the second carrier tape 30b to a second cutting position P4. The second cutting position P4 is the position where the second cutting mechanism 44b cuts the second carrier tape 30b. The second tape feed mechanism 42b is constituted by a sprocket that engages with the feed holes Hc of the second carrier tape 30b, and a motor, a gear, etc., that controls the rotation of this sprocket.

The second sensor module 5b includes an optical displacement sensor. The second sensor module 5b tests the pocket Pk of the second carrier tape 30b that is fed in from the second tape feed mechanism 42b (hereinafter this pocket will be referred to as the second pocket Pk2), using a second trigger signal S2a sent in from the controller 40 as a trigger. The second sensor module 5b then determines whether or not this second pocket Pk2 is holding an electronic component e. The top tape Tt of the second carrier tape 30b is preferably transparent so that the second sensor module 5b, which is an optical displacement sensor, can make this determination. The place where the second sensor module 5b tests the second pocket Pk2 is called the second tape testing position P3. The second tape testing position P3 is a measurement region in which the second sensor module 5b can measure displacement. The second tape testing position P3 is located in the upper side than the second cutting position P4. That is, the second pocket Pk2 of the second carrier tape 30b arrives at the second tape testing position P3 before it arrives at the second cutting position P4. The second sensor module 5b sends a second output signal S2b indicating the determination result for the second pocket Pk2 to the controller 40. The configuration and operation of the second sensor module 5b will be described in detail below.

The second cutting mechanism 44b cuts the second carrier tape 30b at the second cutting position P4. The second cutting mechanism 44b includes, for example, a cutter and a pressing member that is used for fixing the second carrier tape 30b. The second cutting mechanism 44b is driven by a drive signal from the controller 40.

The second movable conveyance path 46b sends to the second disposal site 48b the portion of the second carrier tape 30b that has been cut off by the second cutting mechanism 44b and is no longer needed. The second movable conveyance path 46b then sends to the tape splicing position P5 the second carrier tape 30b that has been cut by the second cutting mechanism 44b and is to be spliced with the first carrier tape 30a. The second movable conveyance path 46b is constituted, for example, by a movable member that is driven by a solenoid or the like.

The second positioning mechanism 50b positions the cut second carrier tape 30b at the tape splicing position P5. The second positioning mechanism 50b fixes the second carrier tape 30b when the first carrier tape 30a and the second carrier tape 30b are being spliced. For example, the second positioning mechanism 50b is a mechanism that clamps the second carrier tape 30a with members including a positioning pin and a positioning hole from above and below.

The tape splicing mechanism 52 splices the first carrier tape 30a and the second carrier tape 30b with splicing tape Ts1 and Ts2 at the tape splicing position P5. FIG. 3 shows the tape splicing mechanism 52 as including an upper splicing mechanism 52a and a lower splicing mechanism 52b, but the tape splicing mechanism 52 may include just the upper splicing mechanism 52a or the lower splicing mechanism 52b. The upper splicing mechanism 52a, for example, affixes from above the fixed first carrier tape 30a and second carrier tape 30b by pressing through the gap between the first positioning mechanism 50a and the second positioning mechanism 50b. The lower splicing mechanism 52b, for example, affixes from below the fixed first carrier tape 30a and second carrier tape 30b by pressing through the gap between the first positioning mechanism 50a and the second positioning mechanism 50b. Other than this, the tape splicing mechanism 52 may insert a single piece of splicing tape corresponding to the positioning pins of the first positioning mechanism 50a and the second positioning mechanism 50b between the first positioning mechanism 50a and the first carrier tape 30a and between the second positioning mechanism 50b and the second carrier tape 30b, and may affix by pressing from above and below with the first positioning mechanism 50a and the second positioning mechanism 50b.

The controller 40 controls the first tape feed mechanism 42a, the first cutting mechanism 44a, the first movable conveyance path 46a, the first positioning mechanism 50a, the second tape feed mechanism 42b, the second cutting mechanism 44b, the second movable conveyance path 46b, the second positioning mechanism 50b, and the tape splicing mechanism 52. The controller 40 comprises a memory 40a. Tape feed patterns corresponding to the shapes of various carrier tapes are stored in the memory 40a. The first carrier tape 30a and the second carrier tape 30b can be fed at the desired feed rate and feed pitch by inputting a tape standard (the pitching spacing Pp of the pockets Pk) from the worker.

Therefore, the controller 40 can feed the first carrier tape 30a at the pitch of the first pocket Pk1, matching the center of the first pocket Pk1 to the first tape testing position P1, on the basis of the specifications of the carrier tape Tc mentioned above. The controller 40 can detect whether the center of the first pocket Pk1 is aligned with the first tape testing position P1 on the basis of a signal from a sensor mounted to the first tape feed mechanism 42a (such as an encoder that senses the rotational angle of the motor). On the basis of this sensing result, the controller 40 sends the first sensor module 5a the first trigger signal S1 a indicating that the center position of the first pocket Pk1 has reached the first tape testing position P1.

Similarly, the controller 40 can feed the second carrier tape 30b at the pitch of the second pocket Pk2, matching the center of the second pocket Pk2 to the second tape testing position P3. The controller 40 can detect whether the center of the second pocket Pk2 is aligned with the second tape testing position P3 on the basis of a signal from a sensor mounted to the second tape feed mechanism 42b. On the basis of this sensing result, the controller 40 sends the second sensor module 5b the second trigger signal S2a indicating that the center position of the second pocket Pk2 has reached the second tape testing position P3.

Furthermore, upon receiving the first output signal S1b indicating that an electronic component e is held in the first pocket Pk1, the controller 40 drives the first tape feed mechanism 42a so that a first portion of the first carrier tape 30a, which is a portion of the first pockets Pk1 between the pocket located a specific number on the tape splicing position P5 side from the pocket determined to have the electronic component e and the pocket located (the specific number + 1) on the tape splicing position P5 side, will arrive at the first cutting position P2. When the first portion reaches the first cutting position P2, the controller 40 drives the first cutting mechanism 44a to cut the first carrier tape 30a. The controller 40 then drives the first tape feed mechanism 42a and the first movable conveyance path 46a to feed the cut first carrier tape 30a up to the tape splicing position P5.

Also, upon receiving the second output signal S2b indicating that an electronic component is held in the second pocket Pk2, the controller 40 drives the second tape feed mechanism 42b so that a second portion of the second carrier tape 30b, which is a portion of the second pocket Pk2 between the pocket located a specific number on the tape splicing position P5 side from the pocket in which the electronic component e was determined to be present, and the pocket located (the specific number + 1) on the tape splicing position P5 side, will arrive at the second cutting position P4. When the second portion reaches the second cutting position P4, the controller 40 drives the second cutting mechanism 44b to cut the second carrier tape 30b. The controller 40 then drives the second tape feed mechanism 42b and the second movable conveyance path 46b to feed the cut second carrier tape 30b up to the tape splicing position P5. Finally, the controller 40 drives the first positioning mechanism 50a, the second positioning mechanism 50b, and the tape splicing mechanism 52 to splice the first carrier tape 30a and the second carrier tape 30b.

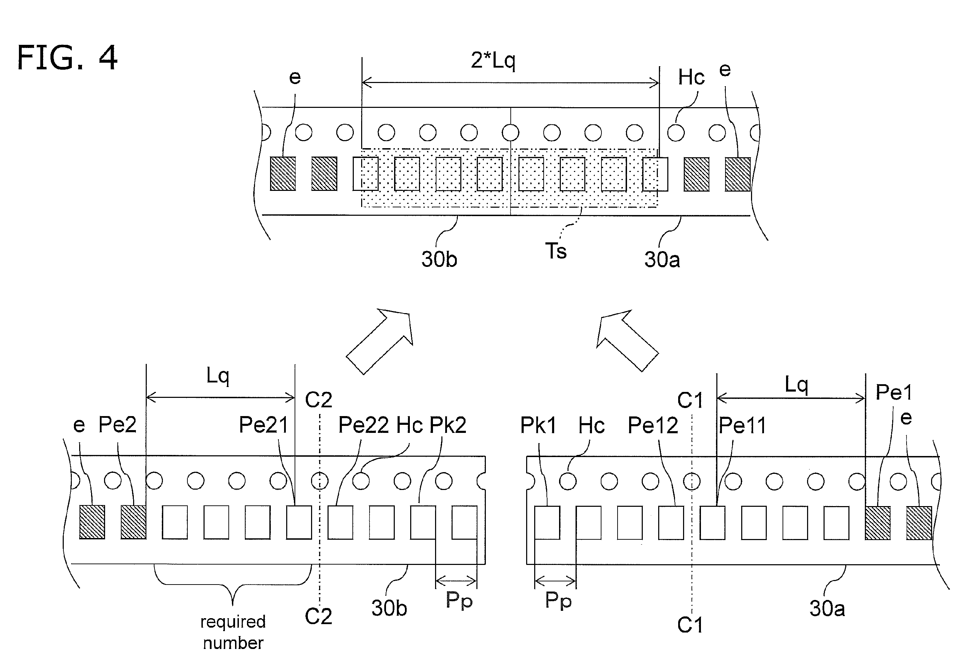

The above-mentioned "specific number" is found from the pitch dp1 of the first pocket Pk1, the pitch dp2 of the second pocket Pk2, and the required length 2 x Lq of the splicing tape Ts. FIG. 4 illustrates tape splicing. In FIG. 4, the required length 2 x Lq of the splicing tape Ts is a length that is sufficient so that the first carrier tape 30a and the second carrier tape 30b will not separate and the splicing position will not shift when the splicing tape Ts is being affixed. This required length is found experimentally, and depends on the width and the material of the carrier tape Tc, the material of the top tape Tt, and the material of the splicing tape Ts. If we assume that splicing tape Ts of the same length Lq is used for the first carrier tape 30a and the second carrier tape 30b, and that the pitch dp1 of the first pocket Pk1 and the pitch dp2 of the second pocket Pk2 are both Pp, the required number N is found from the following Formula 1.

$$N = \{Lq - (Lq \bmod Pp)\} / Pp + 1 \quad \text{(Formula 1)}$$

(Where (a mod b) is the remainder of dividing a by b.)

When the (required number) and the (required number + 1) are thus found, as shown in FIG. 4, the controller 40 cuts the first carrier tape 30a along a cutting line C1-C1, which is a portion of the first pocket Pk1 between a pocket Pe11 located a specific number on the tape splicing position P5 side from the pocket Pe1 where an electronic component e was determined to be present, and a pocket Pe12 located (the specific number + 1) on the tape splicing position P5 side. Also, the controller 40 cuts the second carrier tape 30b along a cutting line C2-C2, which is a portion of the second pocket Pk2 between a pocket Pe21 located a specific number on the tape splicing position P5 side from the pocket Pe2 where an electronic component e was determined to be present, and a pocket Pe22 located (the specific number + 1) on the tape splicing position P5 side. The specific number may be the same as the required number and may be bigger than the required number.

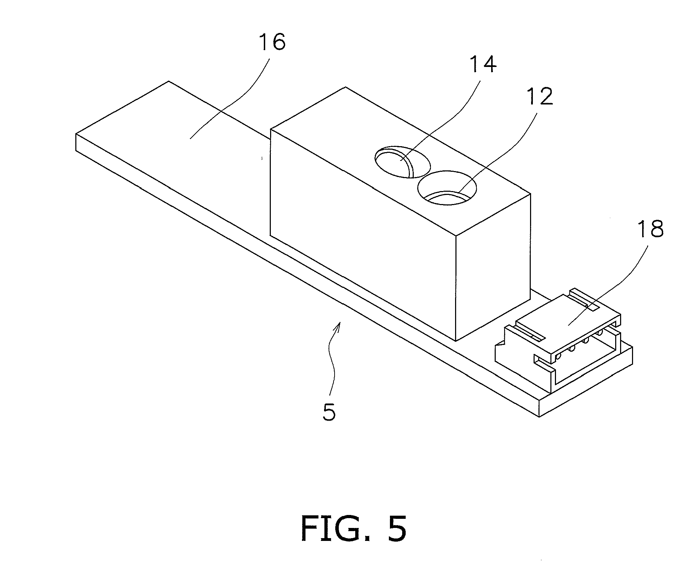

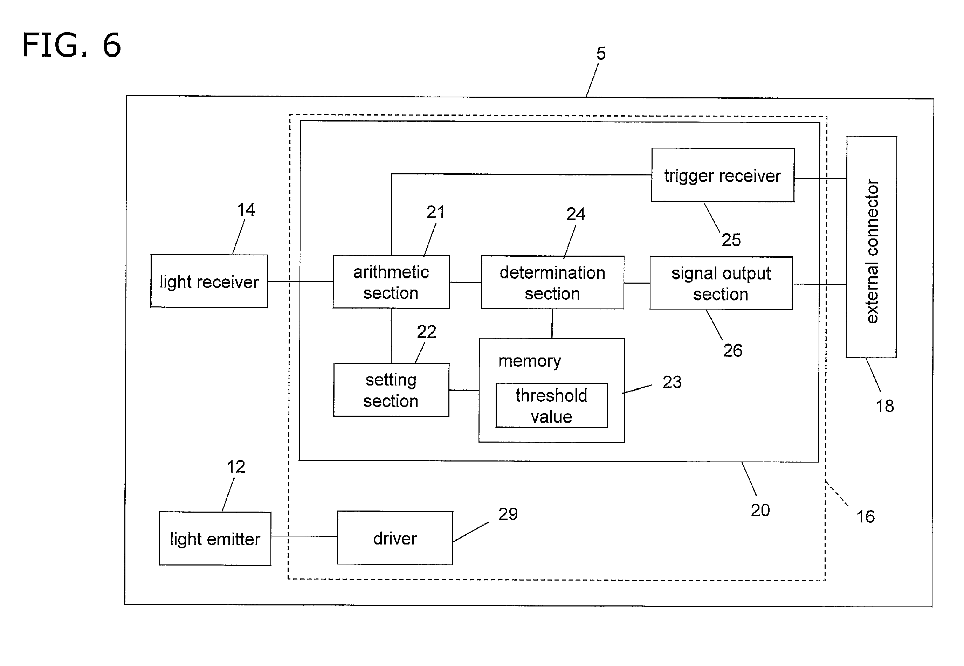

Next, the first sensor module 5a and the second sensor module 5b will be described in detail. Since the first sensor module 5a and the second sensor module 5b are the same module, they will be referred to as the sensor module 5 below. FIG. 5 is an oblique view of the sensor module 5. FIG. 6 is a function block diagram of the sensor module 5.

Referring to FIG. 5, the sensor module 5 has a light emitter 12, a light receiver 14, a substrate 16, and an external connector 18. As shown in FIG. 6, part of the circuits of the light emitter 12 and the light receiver 14, a processing circuit 20, and a driver 29 are mounted on the substrate 16. The processing circuit 20 is typically installed in a microcomputer. The driver 29 may be installed in the same microcomputer as the processing circuit 20, or may be installed in a different microcomputer. The processing circuit 20 has an arithmetic section 21, a setting section 22, a memory 23, a determination section 24, a trigger receiver 25, and a signal output section 26.

The sensor module 5 has an optical displacement sensor formed by the light emitter 12, the light receiver 14, and the arithmetic section 21. Specifically, the light emitter 12 emits light, and the light receiver 14 receives light that has been emitted by the light emitter and reflected by an object. The arithmetic section 21 computes the displacement of an object from the intensity of the light received by the light receiver. FIG. 5 shows an example of a reflecting type of optical displacement sensor, but a transmitting type of displacement sensor may be used instead. In that case, the light receiver 14 is disposed opposite the light emitter 12 and receives light that has been emitted by the light emitter 12 and transmitted by the object.

The light emitter 12 typically comprises a light emitting element, a first lens, and a current supply circuit. The light emitting element is a light emitting diode, for example. The first lens converges the light emitted by the light emitting element in a specific measurement region. The current supply circuit supplies current to the light emitting element when a drive signal is received from the driver 29. The driver 29 supplies drive voltage to the current supply circuit steadily or at regular intervals. Consequently, the light emitter 12 emits light steadily or at regular intervals. The light receiver 14 typically comprises a light receiving element, a second lens, a current-voltage conversion circuit, an amplifier, and an A/D converter. The light receiving element is a photodiode, for example. The second lens converges light from an object toward the light receiving element. The current-voltage conversion circuit converts optical current from the light receiving element into voltage. The amplifier amplifies the converted voltage. The A/D converter converts the amplified voltage into a digital value. The current supply circuit, the current-voltage conversion circuit, the amplifier, and the A/D converter are typically mounted on the substrate 16. The hardware configurations given above for the light emitter 12 and light receiver 14 are merely examples, and any hardware may be used as long as it has the precision to measure the electronic components e and the pockets Pk of the carrier tape Tc.

The trigger receiver 25 receives trigger signals from the controller 40 via the external connector 18 from a carrier tape feed mechanism (here, the controller 40 of the splicing device 1). The above-mentioned first trigger signal S1 a and second trigger signal S2a are trigger signals of the same format. These trigger signals indicate that the measurement region of the sensor has received the center position of a pocket Pk. More specifically, a trigger signal is a pulse wave in which high voltage results when the measurement region of the sensor has received the center position of a pocket Pk, and low voltage results when the measurement region of the sensor has not received the center position of a pocket Pk. The trigger receiver 25 actuates the arithmetic section 21 when the signal changes from low voltage to high voltage.

The arithmetic section 21 computes displacement by measuring optical current from the light emitting element of the light receiver 14 upon being actuated by the trigger receiver 25. When the arithmetic section is actuated is when the center of the first pocket Pk1 (or the second pocket Pk2) arrives at the first tape testing position P1 (or the second tape testing position). Therefore, when the light emitter 12 emits light at the first pocket Pk1 (or the second pocket Pk2) of the first carrier tape 30a (or the second carrier tape 30b), the arithmetic section 21 calculates displacement from the intensity of the light received by the light receiver 14. To put this another way, the arithmetic section 21 computes displacement from the intensity of the light received by the light receiver when the trigger receiver 25 has received a trigger signal.

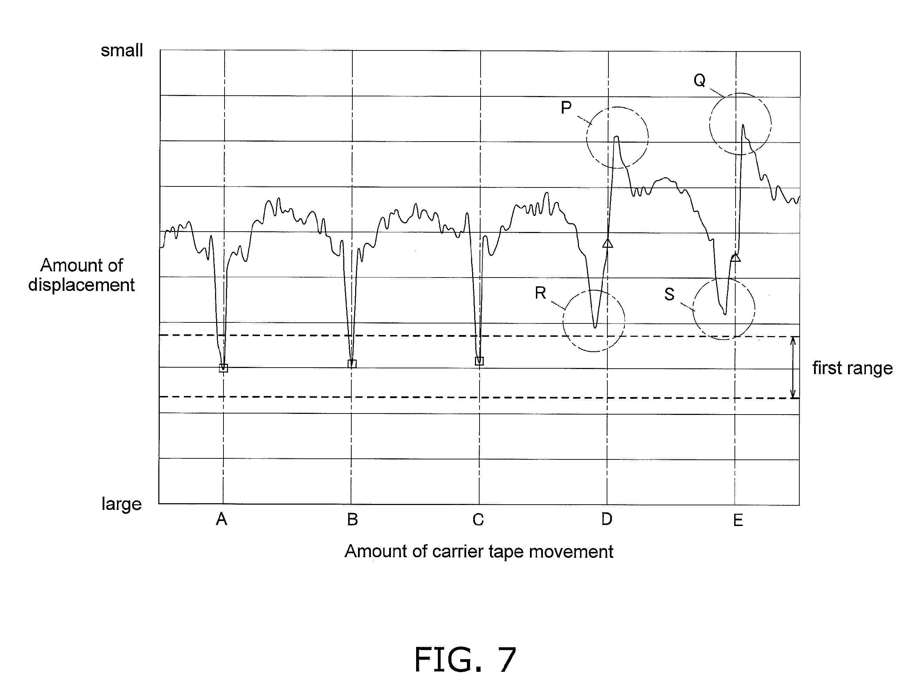

We will now explain the reason why the arithmetic section 21 calculates displacement when the center of the first pocket Pk1 (or the second pocket Pk2) matches up with the first tape testing position P1 (or the second tape testing position P3). FIG. 7 is a graph showing an example of displacement that changes when the carrier tape is moved continuously. In FIG. 7, the center positions of pockets Pk that are not holding electronic components e (empty pockets) are at A, B, and C, and the center positions of pockets Pk that do hold electronic components e (pockets having components) are at D and E.

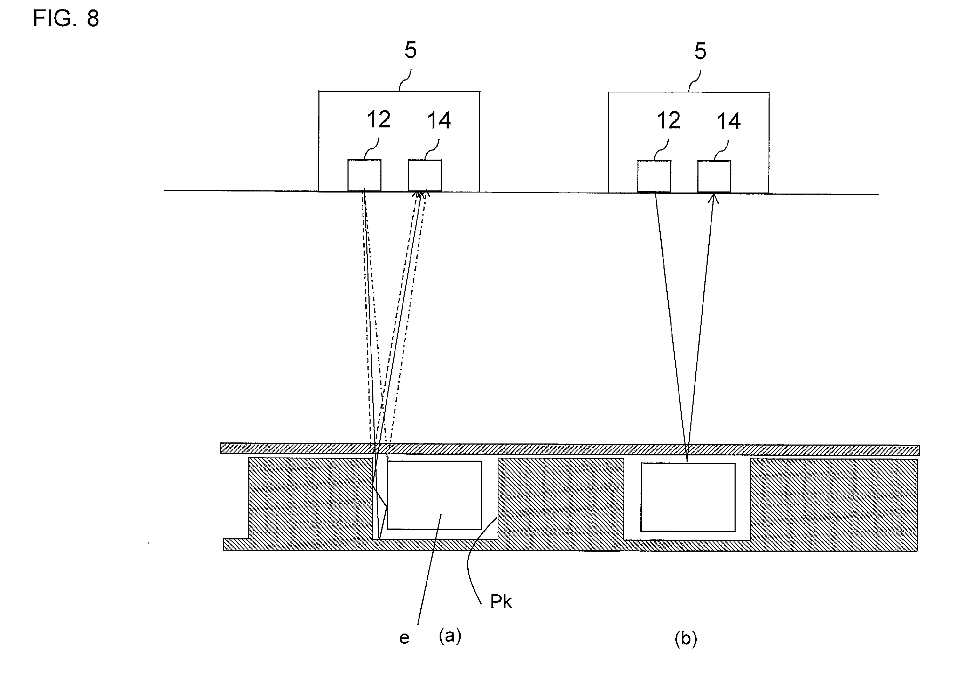

As shown in FIG. 8(a), with a pocket having a component, when the measurement region of the sensor is located in an edge region of the pocket Pk, the light emitted from the light emitter 12 will be reflected at various places, such as the edge of a pocket Pk (shown by a dotted line), the bottom of a pocket Pk (shown by a straight line), or the edge of an electronic component e (shown by a one-dot chain line), and this light interferes. The interfering light is incident on the light receiver 14. P and Q in FIG. 7 are signals when light that has been intensified by interference is incident on the light receiver 14. R and S in FIG. 7 are signals when light that has been weakened by interference is incident on the light receiver 14, or when displacement has increased because the measurement region of the sensor is located at the bottom of the pocket Pk. Since displacement thus fluctuates greatly at the edge regions of the pockets Pk, the edge regions of the pockets Pk are not suited to identifying whether a pocket is empty or has a component.

Meanwhile, as shown in FIG. 8(b), at the center position of a pocket Pk, only light from the electronic component e is reflected, or only light from the bottom of the pocket Pk is reflected. Accordingly, stable output tends to be obtained, as indicated by the small circles and small triangles in FIG. 7. Therefore, in this embodiment, the arithmetic section 21 calculates displacement when the center of the first pocket Pk1 (or the second pocket Pk2) matches up with the first tape testing position P1 (or the second tape testing position).

The setting section 22 statistically processes displacement obtained when light is emitted by the light emitter and received by the light receiver, for the plurality of first pockets Pk1 (or second pockets Pk2) in the first carrier tape 30a (or the second carrier tape 30b). The setting section 22 then sets a first range (or second range) for identifying empty pockets. The first range here refers to the range set by the first sensor module 5a, and the second range refers to the range set by the second sensor module 5b. The range is divided into a first range and a second range only to distinguish between the range set by the first sensor module 5a and the range set by the second sensor module 5b, and the processing performed by the setting section 22 is the same.

Next, the specific processing performed by the setting section 22 and the controller 40 will be described. Empty pockets are disposed continuously at the front and rear ends of the carrier tape Tc wound onto a reel, as spaces for affixing the splicing tape. Therefore, the measurement result for the empty pocket (an example of a predetermined empty pocket) located at the front end of the carrier tape Tc can be utilized in the setting of the first range. The controller 40 sends a command prompting the actuation of the setting section in addition to the above-mentioned trigger signal, which allows the setting section 22 to set a threshold value for determining the first range, on the basis of the result calculated by the arithmetic section 21. The setting section 22 may count how many times the trigger signal is at high voltage, and operate only after the first M number of times. In this case, the integer M expressing the number of times should be stored ahead of time in the memory 23. The first range is found from the standard deviation $\sigma$ and the average value da for displacement in a plurality of empty pockets. More specifically, the first range is preferably a range within n multiples of the standard deviation $\sigma$ and the average value da for displacement in a plurality of empty pockets. In FIG. 7, the boundary of the first range (the second range in the second sensor module 5b) when n is 4 is shown by a dotted line. As shown in FIG. 7, empty pockets can be distinguished from pockets that have a component by setting the first range in this way.

Next, the optimal value of n will be discussed. Table 1 shows the detection accuracy when an electronic component measuring 0.4 x 0.2 mm was identified in the first range when n was varied. Table 2 shows the detection accuracy when an electronic component measuring 0.6 x 0.3 mm was identified in the first range when n was varied. Table 3 shows the detection accuracy when an electronic component measuring 1.0 x 0.5 mm was identified in the first range when n was varied. Table 4 shows the detection accuracy when an electronic component measuring 1.6 x 0.8 mm was identified in the first range when n was varied. Tables 1 to 4 give the values obtained in a simulation using actual measurement results.

Table 1

| Threshol d | 1σ | 2σ | 3σ | 4σ | 5σ | 6σ | 7σ |
|---|---|---|---|---|---|---|---|
| FPR | 0.00% | 0.00% | 0.00% | 0.00% | 0.00% | 0.01% | 0.05% |
| FNR | 15.87% | 2.38% | 0.13% | 0.00% | 0.00% | 0.00% | 0.00% |

Table 2

| Threshol d | 1σ | 2σ | 3σ | 4σ | 5σ | 6σ | 7σ |
|---|---|---|---|---|---|---|---|
| FPR | 0.00% | 0.00% | 0.00% | 0.00% | 0.00% | 0.00% | 0.00% |
| FNR | 15.87% | 2.38% | 0.13% | 0.00% | 0.00% | 0.00% | 0.00% |

Table 3

| Threshol d | 1σ | 2σ | 3σ | 4σ | 5σ | 6σ | 7σ |
|---|---|---|---|---|---|---|---|
| FPR | 0.00% | 0.00% | 0.00% | 0.00% | 0.00% | 0.00% | 0.00% |
| FNR | 15.87% | 2.38% | 0.13% | 0.00% | 0.00% | 0.00% | 0.00% |

Table 4

| Threshol d | 1σ | 2σ | 3σ | 4σ | 5σ | 6σ | 7σ |
|---|---|---|---|---|---|---|---|
| FPR | 0.00% | 0.00% | 0.00% | 0.00% | 0.00% | 0.00% | 0.00% |
| FNR | 15.87% | 2.38% | 0.13% | 0.00% | 0.00% | 0.00% | 0.00% |

The above-mentioned FPR stands for false positive rate, and indicates the rate at which a pocket is detected as an empty pocket even though it actually contains a component. FNR stands for false negative rate, and indicates the rate at which a pocket is not detected as an empty pocket (that is, at which it is detected as containing a component) even though it is actually an empty pocket. As is clear from Tables 1 to 4, the detection accuracy is highest when n = 4 or n = 5. When a pocket is detected as an empty pocket even though it actually contains a component, this is linked to an increase in the frequency at which components are discarded, and is therefore undesirable. In view of this, the first range is most preferably determined to be a range within four times the standard deviation σ and the average value for the measurement result of a plurality of empty pockets (the measured amount of displacement).

The setting section 22 stores threshold values that define the first range (such as da - 4σ, da + 4σ) in the memory 23. Alternatively, the setting section 22 may store the value of the standard deviation σ and the average value da. Therefore, the memory 23 holds threshold values that define the first range and are used to identify empty pockets.

The determination section 24 refers to the threshold values stored in the memory 23, or to data defining the first range, and determines whether a pocket Pk corresponding to the displacement calculated by the arithmetic section 21 is an empty pocket or a pocket having a component. More specifically, the determination section 24 determines the pocket Pk to be an empty pocket when the displacement calculated by the arithmetic section 21 is within the first range. The determination section 24 determines the pocket Pk to be a pocket having a component when the displacement calculated by the arithmetic section 21 is outside the first range. That is, the determination section 24 determines that an electronic component e is present in this pocket Pk.

The signal output section 26 outputs the determination result from the determination section 24 to an external device (here, the controller 40 of the splicing device 1). This output signal is, for example, a rectangular wave in which the voltage is high when the pocket Pk is a pocket having a component, and the voltage is low when the pocket Pk is an empty pocket.

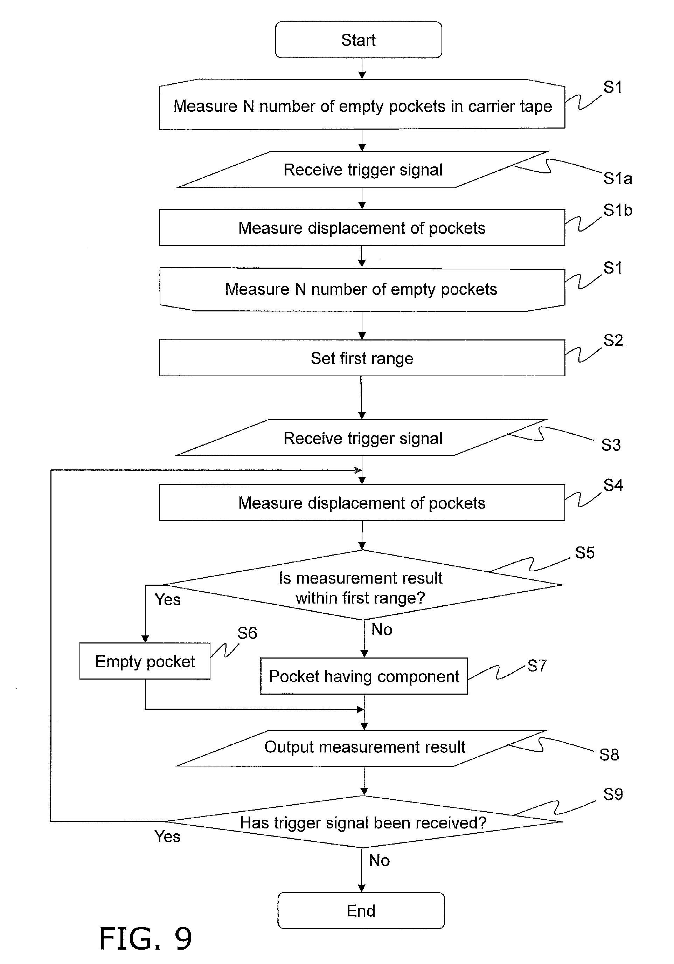

Next, we will describe the flow of processing performed by this sensor module 5 to detect components in a carrier tape. FIG. 9 is a flowchart showing the flow of processing in the detection method used by the sensor module 5.

First, in step S1, the sensor module 5 measures the displacement of N number (N ≥ 2) of empty pockets (an example of a predetermined empty pockets) in a carrier tape. This value of N is predetermined and stored in the memory 23. More specifically, the trigger receiver 25 receives a trigger signal from an external device (step S1 a). The arithmetic section 21 then measures the displacement of a pocket (step S1 b). After steps S1 a and S1 b have been repeated N number of times, the setting section 22 sets the first range (step S2). More specifically, the setting section 22 calculates the average value da from the N number of measurement results, and calculates the standard deviation σ. Then, the setting section 22 sets da - nσ, da + nσ (n is preferably 4) as the threshold value for the first range. The setting section 22 stores the set threshold value in the memory 23.

When the setting of the first range is finished, in step S3 the trigger receiver 25 receives a trigger signal. Then, in step S4, the arithmetic section 21 measures the displacement of the pocket (an example of an undetermined pocket) to be measured. Next, in step S5, the determination section 24 uses the threshold value stored in the memory 23 to determine whether or not the measured displacement is within the first range. If the measured displacement is within the first range (Yes in step S5), the determination section 24 determines that the pocket being measured is an empty pocket (step S6). If the measured displacement is outside the first range (No in step S5), the determination section 24 determines that the pocket being measured is a pocket having a component (step S7). That is, the determination section 24 determines that there is a component in the pocket being measured. Then, the signal output section 26 outputs an output signal indicating the determination result to an external device (step S8). Next, the trigger receiver 25 confirms whether or not another trigger signal has been received (step S9). If another trigger signal has not been received (No in step S9), the processing is ended, but if another trigger signal has been received (Yes in step S9), the flow returns to step S4.

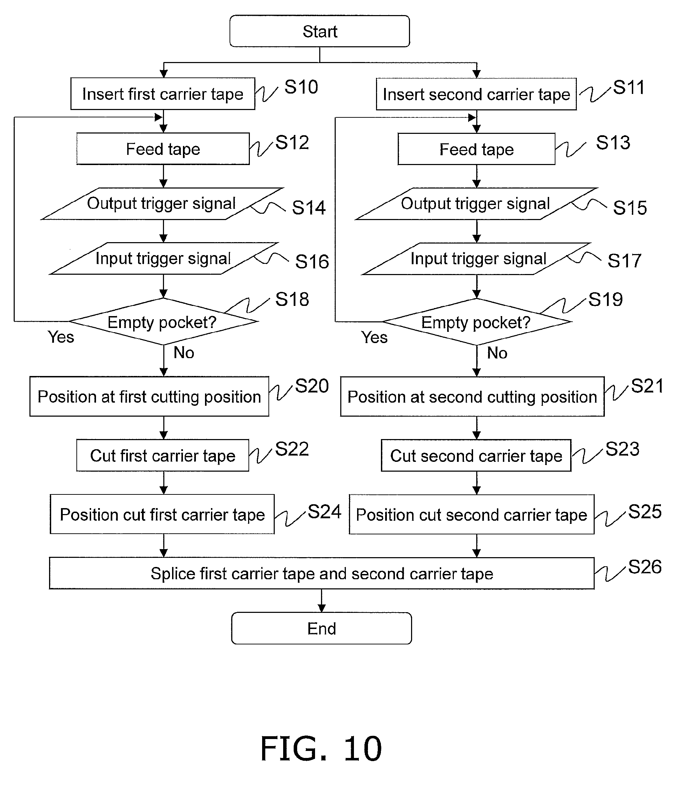

Next, the specific operation of the controller 40 pertaining to this embodiment will be described. FIG. 10 is a flowchart of the flow of operation of the controller 40 of the splicing device 1.

In steps S10 and S11, the first carrier tape 30a and the second carrier tape 30b are inserted. The controller 40 then drives the first tape feed mechanism 42a and the second tape feed mechanism 42b to feed the tape so that the center position of the first pocket Pk1 of the first carrier tape 30a will go to the first tape testing position P1, and the center position of the second pocket Pk2 will go to the second tape testing position P3 (steps S12 and S13). Once the tape feed is finished, the controller 40 outputs the first trigger signal S1a and the second trigger signal S2a to the first sensor module 5a and the second sensor module 5b (steps S14 and S15). The controller 40 then inputs the first output signal S1b and the second output signal S2b, which are the determination results for the first sensor module 5a and the second sensor module 5b (steps S16 and S17). The controller 40 determines whether or not the pockets located at the first tape testing position P1 and the second tape testing position P3 are empty pockets on the basis of the first output signal S1b and the second output signal S2b (steps S18 and S19).

If it is an empty pocket in step S18 (Yes in step S18), the flow returns to step S12. If it is an empty pocket in step S19 (Yes in step S19), the flow returns to step S12. If it is not an empty pocket in step S19 (No in step S18), the controller 40 drives the first tape feed mechanism 42a so that the first portion of the first carrier tape 30a, which is a portion of the first pocket Pk1 between the pocket located a specific number on the tape splicing position P5 side from the pocket in which the electronic component e was determined to be present, and the pocket located (the specific number + 1) on the tape splicing position P5 side, will arrive at the first cutting position P2 (step S20). If it is not an empty pocket in step S19 (No in step S19), the controller 40 drives the second tape feed mechanism 42b so that the second portion of the second carrier tape 30b, which is a portion of the second pocket Pk2 between the pocket located a specific number on the tape splicing position P5 side from the pocket in which the electronic component e was determined to be present, and the pocket located (the specific number + 1) on the tape splicing position P5 side, will arrive at the second cutting position P4 (step S21).

After step S20 is finished, the controller 40 drives the first cutting mechanism 44a to cut the first carrier tape 30a (step S22), and drives the first positioning mechanism 50a to position the cut first carrier tape 30a at the tape splicing position P5 (step S24). After step S21 is finished, the controller 40 drives the second cutting mechanism 44b to cut the second carrier tape 30b (step S23), and drives the second positioning mechanism 50b to position the cut second carrier tape 30b at the tape splicing position P5 (step S25). Finally, the controller 40 drives the tape splicing mechanism 52 to splice the first carrier tape 30a and the second carrier tape 30b (S26).

Second Embodiment

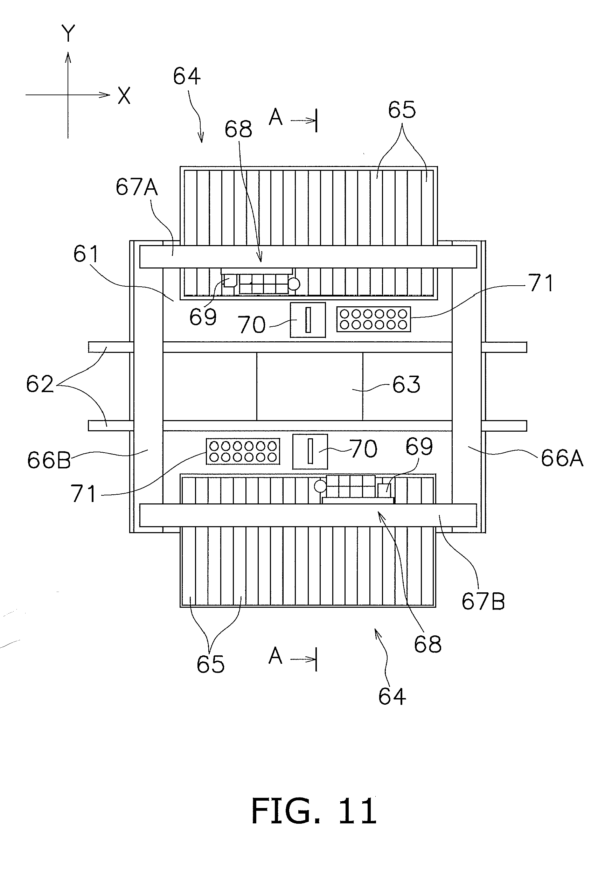

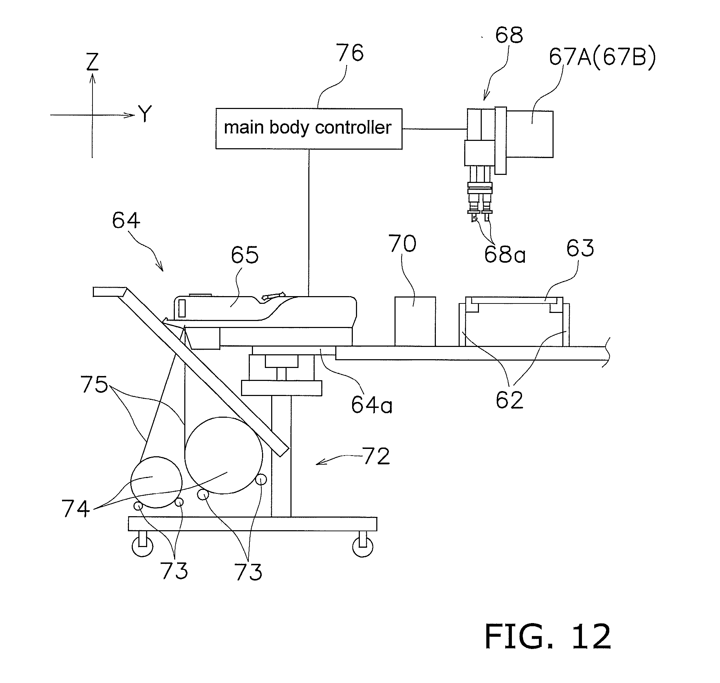

FIG. 11 is a plan view of the component mounting device 3 pertaining to an embodiment of the present invention, and FIG. 12 is a partial cross section of the component mounting device 3 pertaining to an embodiment of the present invention. FIG. 12 partially shows the A-A cross section in FIG. 11. In FIG. 11, conveyance paths 62 are installed in the X direction (the substrate conveyance direction) in the center of a base 61. The conveyance paths 62 convey a substrate 63 that has come in from the upstream side, and positions it on a mounting stage. Component supply section 64 are disposed on both sides of the conveyance paths 62, and a plurality of tape feeders 65 are arranged on each of the component supply section 64. The tape feeders 65 pitch-feed carrier tape that supports electronic components, thereby supplying electronic components to pickup positions with placement heads (discussed below).

Y axis tables 66A and 66B are provided to both ends of the upper face of the base 61, and X axis tables 67A and 67B are provided spanning the Y axis tables 66A and 66B. When the Y axis table 66A is driven, the X axis table 67A moves horizontally in the Y direction, and when the Y axis table 66B is driven, the X axis table 67B moves horizontally in the Y direction. Substrate recognition cameras 69 that move integrally with placement heads 68 are mounted on the X axis tables 67A and 67B.

The Y axis table 66A, the X axis table 67A, the Y axis table 66B, and the axis table 67B are combined and driven to move the placement heads 68 horizontally, electronic components are picked up from the component supply section 64 thereof by suction nozzles 68a (see FIG. 12), and these electronic components are mounted on the substrate 63 positioned on the conveyance paths 62. The operation of the placement heads 68 is controlled by a main body controller 76. The substrate recognition cameras 69 that have moved over the substrate 63 image and recognize the substrate 63. Component recognition cameras 70 and nozzle holders 71 are provided in between the component supply section 64 and the conveyance paths 62.

When the placement heads 68 that have removed the electronic components from the component supply section 64 move to the substrate 63 positioned on the mounting stage, the electronic components held by the suction nozzles 68a are moved in the X direction above the component recognition cameras 70, and the component recognition cameras 70 image the electronic components held by the suction nozzles 68a. The imaging results are subjected to recognition processing by a recognition processor (not shown), so that the positions of the electronic components are recognized while they are being held by the suction nozzles 68a, and the type of electronic components is identified. The nozzle holders 71 perform a nozzle replacement operation in which a plurality of types of suction nozzles 68a are held in a specific orientation and the placement heads 68 access the nozzle holders 71, the result being that the nozzles are replaced according to the type of electronic component in the placement heads 68.

The structure of the component supply section 64 will now be described. As shown in FIG. 12, a feeder base 64a is provided for mounting a plurality of tape feeders 65 to the component supply section 64. The tape feeders 65 are disposed on the component supply section 64 by a feeder mounting truck 72. The truck 72 is provided with reel support components 73 that support tape reels 74 that hold carrier tapes 75 in a wound state. The reel support components 73 are equipped with support rollers for rotatably supporting the tape reels 74, and the carrier tapes 75 can be pulled out by rotating the tape reels 74 disposed on the component supply section 64.

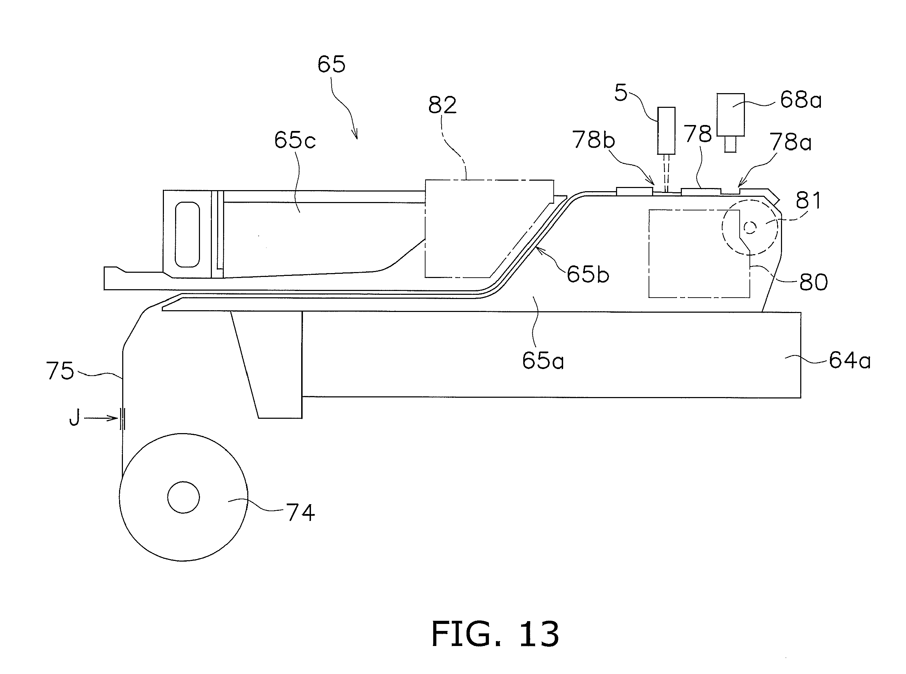

FIG. 13 illustrates the structure of the tape feeders 65 in an embodiment of the present invention. As shown in FIG. 13, a tape travel path 65b over which the carrier tape 75 travels is provided to a frame member 65a mounted to the feeder base 64a. Electronic components e are held in pockets Pk, which are concave components used to hold components and formed at a regular pitch in the carrier tape 75, and the upper faces of the pockets Pk are covered by the top tape Tt.

The carrier tape 75 that has been pulled out from the tape reel 74 is guided from the rear end of the frame member 65a and fed over the upper face of the frame member 65a to the downstream side (the right side in FIG. 13). In the component supply operation in which electronic components are continuously supplied while the carrier tape 75 is fed, if the carrier tape 75 wound around the tape reel 74 should run out, the tape splicing discussed in the first embodiment is carried out. FIG. 13 shows a seam J formed in this tape splicing.

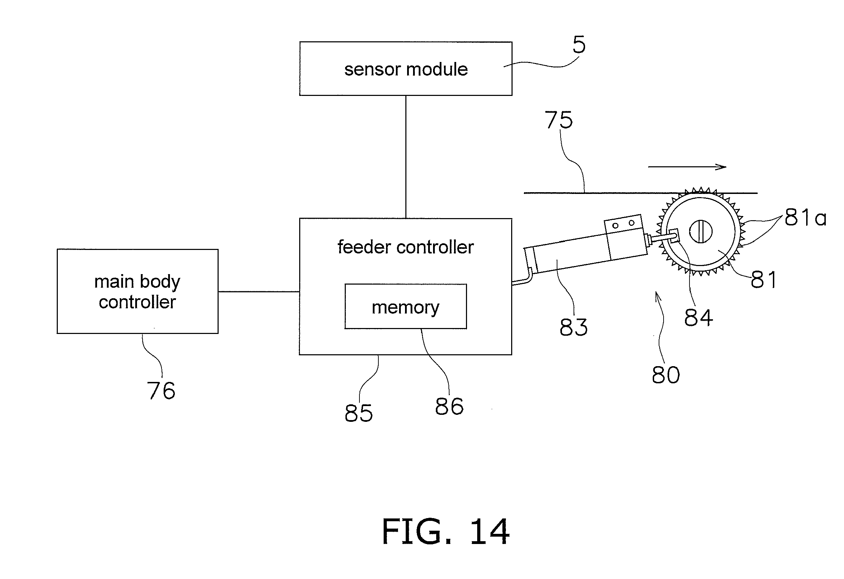

A sprocket 81 driven by a rotational drive mechanism 80 is provided to the upper part on the downstream end of the frame member 65a. As shown in FIG. 14, feed pins 81 a that engage with feed holes Hc made at a regular pitch in the carrier tape 75 (see FIG. 1) are provided to the sprocket 81. The rotational drive mechanism 80 is configured so that the sprocket 81 is rotationally driven via a bevel gear 84 by a motor 83 in which the amount of rotation can be controlled. The sprocket 81 is rotated by driving the motor 83, and this feeds the carrier tape 75 in the downstream direction. The sprocket 81 and the rotational drive mechanism 80 are a tape feed mechanism for the pitch feed of the carrier tapes 75 along the tape travel path 65b.

The motor 83 is controlled by a feeder controller 85, and the feeder controller 85 is controlled by the main body controller 76. The feeder controller 85 is equipped with a memory 86, and the main body controller 76 can write various tape feed patterns to the memory 86. The carrier tape 75 can be fed at the desired feed rate and feed pitch by having the main body controller 76 output an operational command to the feeder controller 85. That is, the main body controller 76 controls not only the placement heads 68, but also the tape feeders 65. Consequently, as will be discussed below, in the process of repeatedly subjecting the carrier tape 75 to intermittent pitch feed at a specific pitch, it is possible for the carrier tapes 75 to be fed in a single feed operation by a batch feed amount of a specific length.

The feeder controller 85 is connected to the above-mentioned sensor module 5. The feeder controller 85 refers to various tape feed patterns in the memory 86 on the basis of operational commands from the main body controller 76. The feeder controller 85 then senses the timing at which the center portion of the pocket Pk reaches the component testing position, which is the measurement region of the sensor module 5, on the basis of the specifications of the above-mentioned carrier tape Tc. The component testing position will be discussed below. The feeder controller 85 then outputs to the sensor module 5 a trigger signal that indicates the sensed timing. The arithmetic section 21 of the sensor module 5 computes displacement from the intensity of the light received by the light receiver 14 when the trigger signal is received. That is, it computes displacement from the intensity of the light received by the light receiver 14 when the pocket Pk reaches the component testing position. The trigger signal may be the same as the one in the first embodiment. In the following description, the feeder controller 85 and the main body controller 76 will be collectively referred to as a controller.

The side of the sprocket 81 where the tape comes to is the component takeoff position where the electronic components e in the pockets Pk are picked up by the suction nozzles 68a of the placement heads 68. An upper guide component 78 that covers and guides above the carrier tape 75 near the component takeoff position is provided to the upper face of the downstream portion of the frame member 65a. The upper guide component 78 has a suction opening 78a and a component testing opening 78b. The component testing opening 78b is located upstream of the suction opening 78a. The upstream end of the component testing opening 78b is provided with a top tape separator for peeling off the top tape Tt. In the process in which the carrier tape 75 travels under the upper guide component 78, the top tape Tt is peeled off by the top tape separator and is folded back toward the upstream side. The folded-back top tape Tt is fed into a tape recovery component 65c by a top tape feed mechanism 82, and recovered.

The pockets Pk exposed when the top tape Tt is peeled off are fed into the component testing opening 78b. The above-mentioned sensor module 5 is provided above the component testing opening 78b. That is, the component testing opening 78b is provided directly under the sensor module 5. The component testing opening 78b is provided in the measurement region of the sensor module 5. Specifically, the component testing opening 78b corresponds to the above-mentioned component testing position. The sensor module 5 measures the center of the pockets Pk of the carrier tape 75 by measuring displacement at a timing based on a trigger signal from the feeder controller 85. Consequently, the sensor module 5 detects whether or not there are components in the pockets Pk. The component detection method employed by the sensor module 5 is the same as that in the first embodiment. The sensor module 5 sends the main body controller 76 an output signal indicating the detection result related to whether or not there are components in the pockets Pk. If a measured pocket Pk is an empty pocket, there is a high probability that the measured pocket is part of the seam J.

The suction opening 78a corresponds to the component takeoff position of the suction nozzles 68a. Usually, the electronic components e are picked up by the suction nozzles 68a from the pockets Pk exposed by peeling off by the top tape. However, if the main body controller 76 receives an output signal indicating that a measured pocket Pk has been determined to be an empty pocket, then when this measured empty pocket is fed into the suction opening 78a, the movement and placement of the electronic components by the placement heads 68 is halted.

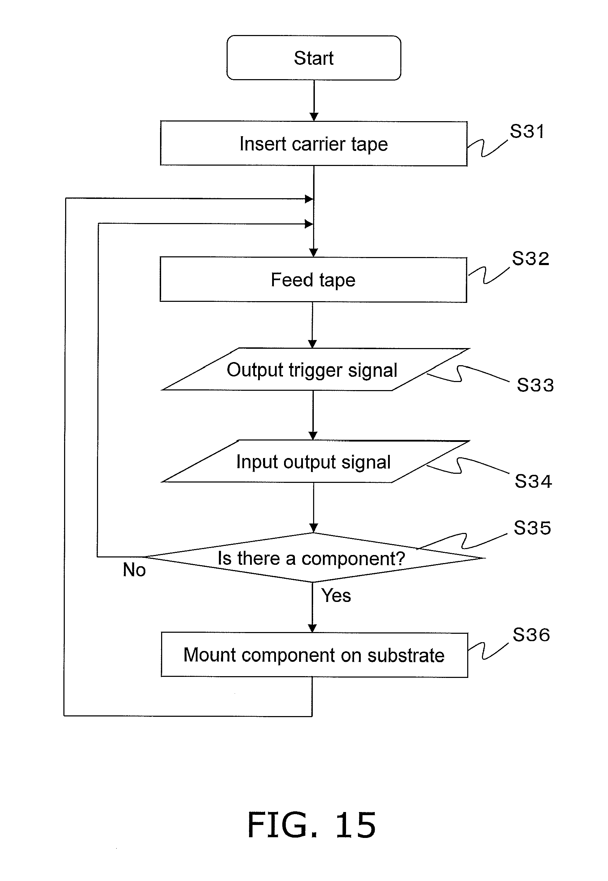

Next, the controller and the operation of the sensor module in this embodiment will now be described. FIG. 15 is a flowchart of the flow of operation of the controller in the component mounting device pertaining to this embodiment. First, in step S31, the carrier tape 75 is inserted into a component mounting device 3. Next, in step S32, the main body controller 76 and the feeder controller 85 feed the tape so that the center position of the pockets Pk of the carrier tape 75 goes to the component testing position (step S32). The feeder controller 85 then outputs a trigger signal to the sensor module 5 (step S33). After the trigger signal has been outputted, the main body controller 76 inputs an output signal indicating the determination result produced by the sensor module 5 (step S34). The main body controller 76 determines whether or not there is a component in the pocket located at the component testing position on the basis of this output signal (step S35). If there is a component (Yes in step S35), when that pocket has reached the component removal position, the main body controller 76 drives the placement head 68 to pick up the electronic component e with the suction nozzle 68a, transfers the component to the substrate 63, and mounts it on the substrate 63 (step S36). If there is no component (No in step S35), then when that pocket reaches the component removal position, the main body controller 76 does not drive the placement head 68, and the processing of step S32 is executed again.

Next, the effect of the sensor modules 5, 5a, and 5b and the splicing device 1 pertaining to the first embodiment, and that of the component mounting device 3 pertaining to the second embodiment will be described. The sensor modules 5, 5a, and 5b, the splicing device 1, and the component mounting device 3 statistically process the displacement of a plurality of empty pockets, and set a first range of displacement in which a pocket is determined to be an empty pocket. If the measured displacement of a pocket is within the first range, that pocket is determined to be an empty pocket, and if the measured displacement of the pocket is outside the first range, a component is determined to be in the pocket. With empty pockets, the amount of displacement tends to be different from that of a tape portion or pocket containing a component. Therefore, whether or not there are components in a carrier tape can be stably detected with a photosensor.

Also, the component mounting device 3 and the splicing device 1 feed the carrier tape so that the measurement region of the sensor modules 5, 5a, and 5b will be located in the center of the pocket of the carrier tape. Displacement is then measured when the sensor modules 5, 5a, and 5b receive a trigger signal indicating that the measurement region of the sensor modules 5, 5a, and 5b is located in the center of the pocket Pk of the carrier tape Tc. The light reception signal of the sensor module at the center position of the pocket Pk of the carrier tape Tc is more stable than in the edge regions of the pocket Pk. Therefore, whether or not there are components in the carrier tape can be detected more stably.

Embodiments of the present invention were described above, but the present invention is not limited to or by the above embodiments, and various modifications are possible without departing from the gist of the invention.

The tape splicing device 1 and the component mounting device 3 discussed above are just examples, and the sensor module 5 of the present invention can be used in the same application in other tape splicing devices 1 and component mounting devices 3.

In the setting of the first range, the median, the mode, or some other statistical value may be used instead of the average value da.

In the first embodiment, the first sensor module 5a and the second sensor module 5b may have a function that excludes the processing circuit 20, and the controller 40 may instead have the function of the processing circuit 20. Similarly, in the second embodiment, the sensor module 5 may have a function that excludes the processing circuit 20, and the feeder controller 85 may instead have the function of the processing circuit 20.

Also, in the second embodiment, the sensor module 5 may be disposed upstream from the position shown in FIG. 13. Upstream from the position shown in FIG. 13, the splicing tape Ts and the top tape Tt are not peeled off of the carrier tape Tc. Therefore, in this case, the splicing tape Ts and the top tape Tt are preferably transparent. Alternatively, the sensor module 5 is preferably able to detect changes in displacement due to the thickness of the splicing tape Ts.

INDUSTRIAL APPLICABILITY

The present invention provides a method that allows the presence of components in a carrier tape to be detected with a photosensor, as well as a sensor module, a splicing device, and a component mounting device that execute said method.

REFERENCE SIGNS LIST

1          splicing device

3     component mounting device
5, 5a, 5b  sensor module

**Claims**

1. A method for detecting whether there are components in a carrier tape with an optical displacement sensor, said method comprising the steps of:

  using the optical displacement sensor to measure the displacement of a plurality of predetermined empty pockets in the carrier tape;
  statistically processing the measured displacement of the predetermined empty pockets, and determining a first range of displacement;
  using the optical displacement sensor to measure the displacement of an undetermined pocket in the carrier tape; and
  determining the undetermined pocket to be an empty pocket if the measured displacement of the undetermined pocket is within the first range of displacement, and determining that the undetermined pocket to be a component-filled pocket if the measured displacement of the pocket is outside the first range of displacement.

2. The method according to Claim 1,
  wherein the optical displacement sensor receives a trigger signal from a carrier tape feed mechanism indicating that the measurement region of the optical displacement sensor has reached the center position of a first predetermined empty pocket or the undetermined pocket, and
  upon receiving the trigger signal, the optical displacement sensor measures the displacement of the first predetermined empty pocket or the displacement of the undetermined pocket.

3. The method according to Claim 1 or 2, wherein the first range of displacement is determined by a standard deviation and an average value of the plurality of the predetermined empty pockets.

4. A sensor module that includes an optical displacement sensor, for detecting the presence of components in a carrier tape, said sensor module comprising:

  a light emitter that emits light for a pocket in the carrier tape;
  a light receiver that receives the light from the light emitter;
  an arithmetic section that calculates displacement from an intensity of light received by the light receiver;
  a setting section that statistically processes displacement obtained when the light receiver receives the light from the light emitter for a plurality of predetermined empty pockets in the carrier tape, and sets a first range of displacement;
  a memory that stores threshold values that define the first range; and
  a determination section that determines an undetermined pocket to be an empty pocket if the calculated displacement is within the first range of displacement, and determines that the undetermined pocket is a component-filled pocket if the calculated displacement is outside the first range of displacement.

5. The sensor module according to Claim 4, further comprising a trigger receiver that receives a trigger signal indicating that a measurement region of the displacement sensor has reached a center position of a first predetermined empty pocket or the undetermined pocket,
  wherein the arithmetic section calculates the displacement from the intensity of light received by the light receiver when the trigger receiver has received the trigger signal.

6. The sensor module according to Claim 4 or 5, wherein the first range of displacement is defined by a standard deviation and an average value of displacement of the plurality of the predetermined empty pockets.

7. A component mounting device, comprising:

  a tape feeder that sends a component held in an undetermined pocket of a carrier tape to a component removal position;
  a placement head that removes the components from the undetermined pocket and moves them for placement on a substrate; and

a controller that controls the tape feeder and the placement head,
wherein the tape feeder has a sensor module that includes;

an optical displacement sensor,
a light emitter that emits light for a pocket in the carrier tape,
a light receiver that receives the light from the light emitter,
an arithmetic section that calculates displacement from an intensity of light received by the light receiver when the undetermined pocket has arrived at a component testing position before arriving at the component removal position,
a memory that stores threshold values that define a first range of displacement,
a determination section that determines the undetermined pocket to be an empty pocket if the calculated displacement is within the first range of displacement, and determines that a component is in the undetermined pocket if the calculated displacement is outside the first range of displacement, and
a signal transmitter that transmits to the controller an output signal indicating a pocket determination result produced by the determination section; and wherein

upon receipt of the output signal indicating that the undetermined pocket was determined to be the empty pocket, the controller halts movement and placement by the placement head when the empty pocket is sent to the component removal position.

8. The component mounting device according to Claim 7, wherein the sensor module further includes a setting section that statistically processes displacement obtained when the light receiver receives the light from the light emitter for a plurality of predetermined empty pockets in the carrier tape, and sets the first range of displacement.

9. The component mounting device according to Claim 8, wherein the controller sends the sensor module a trigger signal indicating that a center position of the undetermined pocket or a first predetermined empty pocket has arrived at the component testing position,
the sensor module further includes a trigger receiver that receives the trigger signal, and
the arithmetic section calculates the displacement from the intensity of light received by the light receiver when the trigger receiver has received the trigger signal.

10. The component mounting device according to any of Claims 8 to 9, wherein the first range is defined by a standard deviation and an average value of displacement of the plurality of predetermined empty pockets.

11. A splicing device that splices a first carrier tape and a second carrier tape, comprising:

a first tape feed mechanism that feeds the first carrier tape to a first cutting position;
a first sensor module that includes a first optical displacement sensor;
a first cutting mechanism that cuts the first carrier tape at the first cutting position;
a first positioning mechanism that positions the cut first carrier tape at a tape splicing position;
a second tape feed mechanism that feeds the second carrier tape to a second cutting position;
a second sensor module that includes a second optical displacement sensor;
a second cutting mechanism that cuts the second carrier tape at the second cutting position;
a second positioning mechanism that positions the cut second carrier tape at the tape splicing position;
a tape splicing mechanism that splices the first carrier tape and the second carrier tape with splicing tape at the tape splicing position; and
a controller that controls the first tape feed mechanism, the first cutting mechanism, the first positioning mechanism, the second tape feed mechanism, the second cutting mechanism, the second positioning mechanism, and the tape splicing mechanism,
wherein the first sensor module includes:

a first light emitter that emits light for a first pocket in the first carrier tape;
a first light receiver that receives the light from the first light emitter;
a first arithmetic section that calculates a first displacement from a first intensity of light received by the first light receiver when the first pocket of the first carrier tape has arrived at a first tape testing position before arriving at the first cutting position;
a first memory that stores threshold values that define a first range of the first displacement;
a first determination section that determines the first pocket to be a first empty pocket if the first displacement is within the first range, and determines the first pocket to be a first component-filled pocket if the first displacement is outside the first range; and

a first signal transmitter that transmits to the controller a first output signal indicating the first pocket determination result produced by the first determination section,

the second sensor module includes:

a second light emitter that emits light for a second pocket in the second carrier tape;

a second light receiver that receives the light from the second light emitter;

a second arithmetic section that calculates a second displacement from a second intensity of light received by the second light receiver when the second pocket of the second carrier tape has arrived at a second tape testing position before arriving at the second cutting position;

a second memory that stores threshold values that define a second range of the second displacement;

a second determination section that determines the second pocket to be a second empty pocket if the second displacement is within the second range, and determines that the second pocket is a second component-filled pocket if the second displacement is outside the second range; and

a second signal transmitter that transmits to the controller a second output signal indicating the second pocket determination result produced by the second determination section, and

the controller:

upon receiving the first output signal indicating that the first determination section has determined that there is the first component-filled pocket, causes the first cutting mechanism to cut the first carrier tape when a first portion of the first carrier tape, which is a portion between a pocket located a specific number on the tape splicing position side from the first component-filled pocket was determined to be present, and a specific number + 1 pocket located on the tape splicing position side from the first component-filled, arrives at the first cutting position, and

upon receiving the second output signal indicating that the second determination section has determined that there is the second component-filled pocket, causes the second cutting mechanism to cut the second carrier tape when a second portion of the second carrier tape, which is a portion of the second pocket between the pocket located a specific number on the tape splicing position side from the second component-filled pocket, and the specific number + 1 pocket located on the tape splicing position side from the second component-filled pocket, arrives at the second cutting position.

12. The splicing device according to Claim 11, wherein the specific number is found from a pitch of the first pocket and a pitch of the second pocket, and a required length of the splicing tape.

13. The splicing device according to Claim 11 or 12,
wherein the first sensor module further includes a first setting section that statistically processes the first displacement obtained when the first light receiver receives the light from the first light emitter for a first plurality of predetermined empty pockets of the first carrier tape, and sets the first range, and
the second sensor module further includes a second setting section that statistically processes the second displacement obtained when the second light receiver receives the light from the second light emitter for a second plurality of predetermined empty pockets of the second carrier tape, and sets the second range.

14. The splicing device according to Claim 13,
wherein the controller sends the first sensor module a first trigger signal indicating that the center position of the first pocket has arrived at the first tape testing position,
the first sensor module further includes a first trigger receiver that receives the first trigger signal,
the first arithmetic section calculates the first displacement from the first intensity of light received by the first light receiver when the first trigger receiver has received the first trigger signal,
the controller sends the second sensor module a second trigger signal indicating that the center position of the second pocket has arrived at the second tape testing position,
the second sensor module further includes a second trigger receiver that receives the second trigger signal, and
the second arithmetic section calculates the second displacement from the second intensity of light received by the second light receiver when the second trigger receiver has received the second trigger signal.

15. The splicing device according to any of Claims 13 to 14, wherein the first range is defined by a standard deviation and an average value of the first displacement of the first predetermined plurality of empty pockets, and the second range is defined by a standard deviation and an average value of the second displacement of the second predetermined plurality of empty pockets.

# FIG. 1

# FIG. 2

FIG. 3

# FIG. 4

FIG. 5

# FIG. 6

FIG. 7

EP 2 919 573 A2

FIG. 8

EP 2 919 573 A2

FIG. 9

Start

Insert first carrier tape — S10

Insert second carrier tape — S11

Feed tape — S12

Feed tape — S13

Output trigger signal — S14

Output trigger signal — S15

Input trigger signal — S16

Input trigger signal — S17

Empty pocket? — S18

Empty pocket? — S19

Yes

No

Yes

No

Position at first cutting position — S20

Position at second cutting position — S21

Cut first carrier tape — S22

Cut second carrier tape — S23

Position cut first carrier tape — S24

Position cut second carrier tape — S25

Splice first carrier tape and second carrier tape — S26

End

FIG. 10

FIG. 11

FIG. 12

EP 2 919 573 A2

FIG. 13

sensor module — 5

75

feeder controller

main body controller

memory

76

85   86

83

80

84

81a

81

FIG. 14

FIG. 15

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013157109 A
- JP 2007214476 A